# EUROPEAN PATENT SPECIFICATION

(11) **EP 2 601 822 B1**
(45) Date of publication and mention of the grant of the patent: **10.07.2019**
(21) Application number: 11737966.9
(22) Date of filing: 29.07.2011
(51) Int. Cl.: H05K 3/24, H05K 3/34, H05K 3/40, H01L 23/498, H01L 21/48, H01L 23/00

(54) **METHOD TO FORM SOLDER DEPOSITS AND NON-MELTING BUMP STRUCTURES ON SUBSTRATES**
VERFAHREN ZUM BILDEN VON LÖTABLAGERUNGEN UND NICHTSCHMELZENDEN DÄMPFERSTRUKTUREN AUF SUBSTRATEN
PROCÉDÉ DE FORMATION DE DÉPÔTS DE BRASURE ET DE STRUCTURES BOSSELÉES QUI NE FONDENT PAS SUR DES SUBSTRATS

(30) Priority: 28.03.2011 EP 11160014; 02.08.2010 EP 10171612
(43) Date of publication of application: 12.06.2013
(73) Proprietor: Atotech Deutschland GmbH, 10553 Berlin (DE)
(72) Inventor: MATEJAT, Kai-Jens, 14109 Berlin (DE); LAMPRECHT, Sven, 10589 Berlin (DE); EWERT, Ingo, 14167 Berlin (DE); SCHOENENBERGER, Catherine, F-68510 Rantzwiller (FR); KRESS, Jürgen, CH-4125 Riehen (CH)
(86) International application number: PCT/EP2011/063141
(87) International publication number: WO 2012/016932

(56) References cited:
- EP-A1- 1 542 520
- EP-A1- 2 180 770
- EP-A1- 2 244 285
- US-A1- 2006 079 081
- US-A1- 2006 202 331
- US-A1- 2006 219 567
- US-A1- 2009 205 854

## Description

### Field of the Disclosure

The invention relates to the formation of solder deposits by electroplating, particularly to flip chip packages, more particularly to flip chip joints and board to board solder joints formed by electroplated metal or metal alloys.

### Background of the Invention

Since the introduction of the flip chip technology by IBM in the early 1960s, the flip chip devices have been mounted on an expensive ceramic substrate where the thermal expansion mismatch between the silicon chip and the ceramic substrate is less critical. In comparison with wire bonding technology, the flip chip technology is better able to offer higher packaging density (lower device profile) and higher electrical performance (shorter possible leads and lower inductance). On this basis, the flip chip technology has been industrially practiced for the past 40 years using high-temperature solder (controlled-collapse chip connection, C4) on ceramic substrates. However, in recent years, driven by the demand of high-density, high-speed and low-cost semiconductor devices for the trend of miniaturization of modern electronic products, the flip chip devices mounted on a low-cost organic circuit board (e.g. printed circuit board or substrate) with an epoxy underfill to mitigate the thermal stress induced by the thermal expansion mismatch between the silicon chip and organic board structure have experienced an obviously explosive growth. This notable advent of low-temperature flip chip joints and organic-based circuit board has enabled the current industry to obtain inexpensive solutions for fabrication of flip chip devices.

In the current low-cost flip chip technology, the top surface of the semiconductor integrated circuit (IC) chip has an array of electrical contact pads. The organic circuit board has also a corresponding grid of contacts. The low-temperature solder bumps or other conductive adhesive material are placed and properly aligned in between the chip and circuit board. The chip is flipped upside down and mounted on the circuit board, in which the solder bumps or conductive adhesive material provide electrical input/output (I/O) and mechanical interconnects between the chip and circuit board. For solder bump joints, an organic underfill encapsulant may be further dispensed into the gap between the chip and circuit board to constrain the thermal mismatch and lower the stress on the solder joints.

In general, for achieving a flip chip assembly by solder joints, the metal bumps, such as solder bumps, gold bumps or copper bumps, are commonly pre-formed on the pad electrode surface of the chip, in which the bumps can be any shape, such as stud bumps, ball bumps, columnar bumps, or others. The corresponding solder bumps (or say presolder bumps), typically using a low-temperature solder, are also formed on the contact areas of the circuit board. At a reflow temperature, the chip is bonded to the circuit board by means of the solder joints. After dispensing of an underfill encapsulant, the flip chip device is thus constructed. Such methods are well known in the art and typical examples of the flip chip devices using solder joints are for example described in US 7,098,126.

Currently, the most common method for formation of presolder bumps on the circuit board is the stencil printing method. Some prior proposals in relation to the stencil printing method can be referred to US 5,203,075, US 5,492,266 and US 5,828,128. Solder bumping technique for flip chip assemblies requires design considerations regarding both bump pitch and size miniaturization. According to practical experiences, the stencil printing will become infeasible once the bump pitch is decreased below 0.15 millimeter. In contrast, the solder bumps deposited by electroplating offer the ability to further reduce bump pitch down to below 0.15 millimeter. The prior proposals in relation to electroplate bumps on the circuit board for flip chip bonding can be found in US 5,391,514 and US 5,480,835. Although eletroplate solder bumping on the circuit board offers finer bump pitch over stencil printing, it presents several challenges for initial implementation.

A multi-step process to form solder on an organic substrate is described in US 7,098,126. In the method, there is initially provided an organic circuit board including a surface bearing electrical circuitry that includes at least one contact area. A solder mask layer that is placed on the board surface and patterned to expose the pad. Subsequently, a metal seed layer is deposited by physical vapor deposition, chemical vapor deposition, electroless plating with the use of catalytic copper, or electroplating with the use of catalytic copper, over the board surface. A resist layer is formed over the metal seed layer and then patterned. A solder material is then formed in the opening by electroplating. Finally, the resist and the metal seed layer beneath the resist are removed. To apply this method various patterning steps are required which is not desired from the overall standpoint of process efficiency. Each patterning step is a potential cause of mismatched patterns. Furthermore the method has its limitations if the distance between adjacent contact areas (pitch) is very small as a result of the miniaturization of electronic devices.

A fabrication method of conductive bump structures of circuit boards is disclosed in US 2006/0219567 A1. A solder material is electroplated onto the substrate which is partially protected by a patterned solder mask. Next, an etch resist is deposited onto the layer of solder material. The etch resist is then patterned in a way that the solder material coated connecting pads are protected during the following etching step. Solder material which is not needed for the solder depots is then etched away leaving only the etch resist protected solder depot above the connecting pads. Next, the etch resist is removed.

The European patent application EP 2 180 770 A1 discloses a method for formation of solder deposit layers wherein a solder resin layer is deposited onto a substrate having contact areas. Said solder resin layer is patterned in order to expose said contact areas. Next, an additional resin layer is deposited onto the patterned solder resin layer and again patterned. This method can lead to a misalignement of the individually patterned solder resin layer and additional resin layer in case of small contact area size and narrow pitch distance.

US2006/202331A1 discloses the preamble of claim 1.

### Summary of the Invention

It is therefore an objective of the present invention to adopt an electroplating method of tin and tin alloys to produce a uniform layer of a solder deposit on a substrate and a tin plating bath composition suitable therefore. Such plating methods should be suitable to fill recess structures possessing high aspect ratios without leaving voids or dimples.

Another object of the present invention is to provide non-melting bump structures.

Another object of the present invention is to provide a method for solder deposition and formation of non-melting bump structures having a reduced number of plating steps and which is universally applicable even when the solder resist openings have different dimensions.

Another object of the present invention is to provide a method for solder deposit and non-melting bump structure formation which avoids pattern misalignment.

In summary, a method of fabricating electroplate solder deposits and non-melting bump structures on a substrate for forming flip chip joints and board to board solder joints is disclosed. There is provided a non-conductive substrate like a circuit board including at least one contact area.

A substrate having at least one contact area which is covered by a permanent resin layer are coated with a temporary resin layer. Contact area openings are generated in the substrate by methods such as laser drilling, plasma etching, spark erosion and mechanical drilling in order to expose the at least one contact area.

Next, a layer containing a metal or metal alloy is then plated on the conductive areas of the substrate to form a solder deposit or a non-melting bump structure.

The present invention provides a method according to claim 1 and the dependent claims 2 - 9.

### Brief Description of the Drawings

Fig. 1 shows the two-step formation of contact area openings with misalignment according to processes known in the art.
Fig. 2 shows a method according to the present invention to obtain a metal or metal alloy layer on a substrate.
Fig. 3 shows a method for obtaining non-melting bump structures with a solderable cap layer.
Fig. 4 shows another method for obtaining non-melting bump structures with a solderable cap layer.
Fig. 5 shows still another method for obtaining non-melting bump structures with a solderable cap layer.
Fig. 6 shows a method for obtaining non-melting bump structures with a solderable cap layer separated by a barrier layer.
Fig. 7 shows reflowed solder deposits and non-melting bump structures.

- (101): contact area
- (102): non-conductive substrate
- (103): permanent resin layer
- (104): temporary resin layer
- (105): contact area opening
- (106): first conductive seed layer
- (107): metal or metal alloy layer
- (108): reflowed solder deposit layer
- (109): solder resin layer
- (110): solder resin opening
- (111): temporary resin opening
- (112): non-melting bump structure
- (113): solderable cap layer
- (114): resist layer
- (115): barrier layer
- (116): second conductive seed layer
- (117): protection layer

### Detailed Description of the Invention

The invention provides a method of forming a metal layer on a substrate by electroplating a metal or metal alloy layer. The process is particularly suitable for fabricating solder bumps and non-melting bump structures on a circuit board having a good plating uniformity. The method is in more detail described below. The figures shown herein are simply illustrative of the process. The figures are not drawn to scale, i.e. they do not reflect the actual dimensions or features of the various layers in the chip package structure. Like numbers refer to like elements throughout the description.

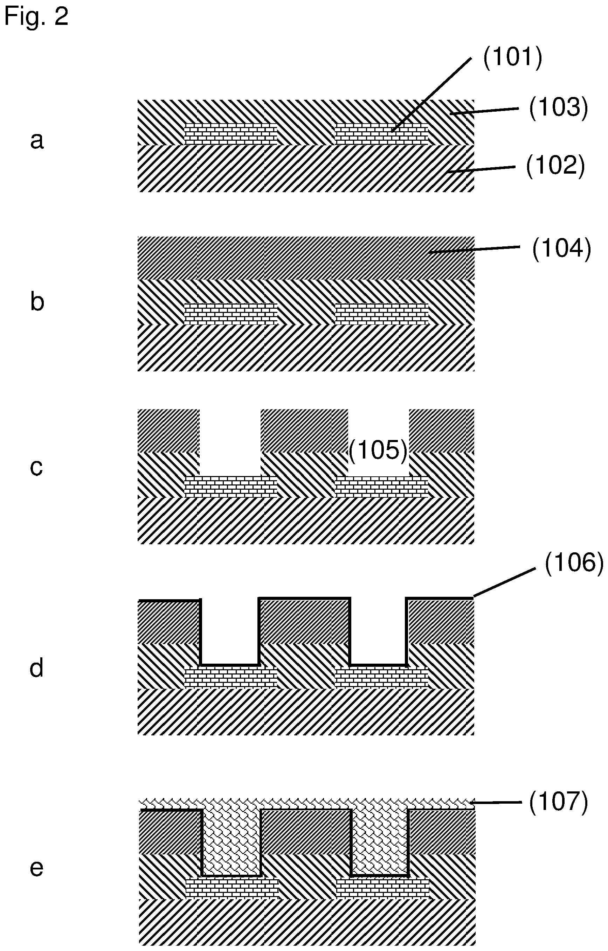

Now referring to Fig. 2, in accordance with a preferred embodiment of the present invention, there is provided a non-conductive substrate (102), which has embedded contact pads as a contact area (101) embodiment (Fig. 2 a). The at least one contact area (101) can be a contact pad, a via or a trench. The non-conductive substrate (102) can be a circuit board which may be made of an organic material or a fiber-reinforced organic material or a particle-reinforced organic material, for example, epoxy resin, polyimide, bismeleimide triazine, cyanate ester, polybenzocyclobutene, or glass fiber composite thereof and the like. The non-conductive substrate (102) may also be part of a wafer or a redistributed wafer. In such a case, a non-conductive surface, e.g., a dielectric material is attached onto the at least one contact area leading to a structure as shown in Fig. 2 a.

The at least one contact area (101) is typically formed from a metal material, such as copper. Optionally, a first barrier layer is formed on the at least one contact area (101) and can e.g. be an adhesive layer of nickel, nickel alloys or a protective layer of gold. Said first barrier layer may also be made of nickel, chromium, titanium, silver, gold, palladium, alloys thereof and multi layers thereof which can be made by electoplating, electroless plating, physical vapor deposition or chemical vapour deposition.

The at least one contact area (101) is covered by at least one permanent resin layer (103) which is preferably made of organic material or a fiber-reinforced organic material or a particle-reinforced organic material, etc., for example, epoxy resin, polyimide, bismeleimide triazine, cyanate ester, polybenzocyclobutene, or glass fiber composite thereof, etc.

In one embodiment of the present invention the permanent resin layer (103) is a solder resin layer.

Next, at least one temporary resin layer (104) is deposited onto the at least one permanent resin layer (103) (Fig. 2 b). The at least one temporary resin layer (104) is selected from materials such as dry film resists, liquid resists and printable resins.

The temporary resin layer (104) may be selected from a polymer material selected from one or more of acrylates, ethylene/ethylacrylate copolymer (EEAC), ethylene/methacrylate copolymer (EMA), ethylene/acrylic acid copolymer (EAA), ethylene/butylacrylate copolymer (EBA), polymethylpentene (PMP) and polymethylmethacrylate (PMMA), .

More preferred polymer materials for the temporary resin layer (104) are selected from the group consisting of acrylates, and polymethylpentene.

Most preferred polymer material for the temporary resin layer (104) are acrylates with a molecular weight M_{w} of 20000-200000, more preferred 25000-150000, and most preferred 30000-100000. The Tg of the polymer shall be in the range of 20-130 °C, more preferred 30-120 °C, and most preferred 40-110 °C, as measured according to ISO11357-1.

A molecular weight too high will lead to reduced solubility in the chosen solvent. With a molecular weight too low, the sensitivity to the process solutions (alkaline, oxidizing, acidic) tends to be insufficient. The Tg must also not be too low because in this case the sensitivity to the polymer film is insufficient at the elevated temperature of the processing chemicals.

Optionally, fillers can be incorporated into the polymeric material of the temporary resin layer (104). Suitable fillers are selected from the group consisting of, aluminium borate, aluminium oxide, aluminiumtrihydroxide, anthracite, sodium antimonate, antimony pentoxide, antimony trioxide, apatite, attapulgite, barium metaborate, barium sulfate, strontium sulfate, barium titanate, bentonite, beryllium oxide, boron nitride, calcium carbonate, calcium hydroxide, calcium sulfate, carbon black, clay, cristobalite, diatomaceous earth, dolomite, ferrites, feldspar, glass beads, graphite, hydrous calcium silicate, iron oxide, kaolin, lithopone, magnesium oxide, mica, molybdenum disulfide, perlite, polymeric fillers such as PTFE, PE, polyimide, pumice, pyrophyllite, rubber particles, fumed silica, fused silica, precipitated silica, sepiolite, quartz, sand, slate flour, talc, titanium dioxide, vermiculite, wood flour, wollastonite, zeolithes, zinc borate, zinc oxide, zinc stannate, zinc sulfide, aramid fibers, carbon fibers, cellulose fibers, and glass fibers and mixtures thereof.

Preferred optional filler materials for the temporary resin layer (104) are selected from the group consisting of fused silica, fumed silica, precipitated silica, dolomite, kaolinite, talc, calcium carbonate, mica, feldspar, vermiculite, and pumice.

Most preferred optional filler materials for the temporary resin layer (104) are selected from the group consisting of kaolinite, talc, mica, and feldspar.

The amount of filler in the overall formulation after removal of the solvent is in the range of 1-70 % by weight, more preferably 2-65 % by weight, most preferably 3-60 % by weight.

The temporary resin layer (104) can be deposited onto the permanent resin layer (103) in form of a liquid by methods such as dip coating, spin coating, bar coating, spraying, screen printing, and roller coating. In another embodiment a dry film on a carrier foil is first made from the liquid resin and this dry film is then laminated on the permanent resin layer (103). Such a carrier foil is required because the polymer materials used later on as the temporary resin layer (104) can not be manufactured as a foil. The preferred method for depositing the temporary resin layer (104) onto the permanent resin layer (103) are roller coating of the liquid resin, screen printing of the liquid resin, dipping of the substrate, or lamination of the respective dry film (consisting of the dry dilm and a carrier foil) onto the substrate. Most preferred are screen printing of the liquid resin, roller coating of the liquid resin, and lamination of a respective dry film (consisting of the dry dilm and a carrier foil) onto the substrate.

Depending on the solvent which was employed for formulating the lacquer, the oven temperature and the drying time have to be adjusted. Important is the resulting hardness of the dried coating. Measurement of the hardness according to Koenig should be in the range of 20 seconds to 200 seconds, more preferred 40 seconds to 180 seconds, most preferred 60 seconds to 160 seconds.

The temporary resin layer (104) can be removed (stripped) from the permanent resin layer (103) by contacting the temporary resin layer (104) with a solvent without damaging the permanent resin layer (103), the solvent selected from the group comprising acetone, n-amylalcohol, n-amylacetate, benzyl alcohol, 1,4-butanediol, methoxybutyl acetate, n-butylacetate, sec-butyl acetate, n-butanol, 2-butanol, butyldiglycol, butyldiglycol acetate, diethyleneglycol dibutylether, butylglycol, butylgycol acetate, n-butyltriglycol, chloroform, cyclohexane, cyclohexanol, cyclohexanone, cyclohexylamine, n-decane, decahydro naphthalene, diacetone alcohol, 1,2-dichloroethane, 1,2-dichlorobenzene, 1,2-dichloropropane, diethanolamine, diethylene glycol, diethyleneglycol dibutylether, diethyleneglycol diethylether, diethyleneglycol dimethylether, diethyleneglycol monobutylether, diethyleneglycol monobutylether acetate, diethyleneglycol monoethylether, diethyleneglycol monomethylether, diethyleneglycol momethylether acetate, diethylether, diethylketone, diethyleneglycol dimethylether, diisobutylketone, diisopropylamine, diisopropanolamine, diisopropylether, dimethylacetamide, dimethylformamide, dimethylsulfoxide, 1,4-dioxane, dipentene, dipropyleneglycol, dipropyleneglycol monobutylether, dipropyleneglycol monomethylether, n-dodecane, propyleneglycol diacetate, propyleneglycol monomethylether, propyleneglycol monomethylether acetate, propyleneglycol monobutylether, propyleneglycol monobutylether acaetate, tripropyleneglycol monomethylether, tripropyleneglycol monobutylether, ethyl-3-ethoxypropionate, ethanolamine, propyleneglycol monoethylether, ethoxypropyl acetate, ethylacetate, ethaylamylketone, ethylbenzene, 2-ethylbutanol, ethylbutyl ketone, ethyldiglycol, ethyldiglycol acetate, 1,2-dichloroethane, ethyleneglycol, ethyleneglycol dietheylether, ethyleneglycol dimethylether, ethyleneglycol monobutylether, ethyleneglycol monobutylether acetate, ethyleneglycol monoethylether, ethyleneglycol monoethylether acetate, ethyleneglycol monoisopropylether, ethyleneglycolmonomethylether, ethyleneglycol monomethylether acetate, ethyleneglycol monopropylether, ethylformiate, ethylglycol, ethylglycol acetate, ethyleneglycol dietehylether, 2-ethoxyethanol, 2-ethylhexyl acetate, ethyllactate, ethylmethylketone, formic acid, ethylmethylketoxime, ethyltriglycol, furfurol, furfurylalcohol, furfurylaldehyde, glycerol, glycerol triacetate, n-heptane, n-hexadecane, n-hexane, hexylene glycol, isoamylacetate, isoamylalcohol, isobutylacetate, isobutylalcohol, isoheptane, isooctane, isopentane, isophorone, isopropanolamine, isopropylacetate, isopropylalcohol, isopropylchloride, isopropylether, isopropylglycol, methoxypropyl acetate, methylacetate, methyl alcohol, methylamylketone, methylbutylketone, methylcyclohexane, methylcyclohexanol, methylcyclohexanone, methylcyclopentane, methyldiglycol, methyldiglycol acetate, methylenechloride, acetic acid, methylethylketone, methylethyl ketoxime, methylglycol, methylglycol acetate, methylisoamylalcohol, methylisoamylketone, methylisobutylcarbinol, methylisobutylketone, methyl isopropyl ketone, methylpropylketone, N-methylpyrrolidone, methyl-t-butylether, monochlorobenzene, monoethanolamine, monoisopropanolamine, nitroethane, nitromethane, 1-nitropropane, 2-ntropropane, n-nonane, n-octane, n-octylalcohol, n-pentadecane, pentylpropionate, perchloroethylene, n-propylacetate, n-propanol, propylenedichloride, propyleneglycol, propyleneglycol diacetate, propyleneglycol monobutylether, propyleneglycol monobutyletheracetate, propyleneglycol monoethylether, propyleneglycol monomethylether, propyleneglycol monomethylether acetate, propylglycol, pyridine, sec-butylacetate, n-tetradecane, tetraethyleneglycol, tetraethyleneglycol dimethylether, tetrahydrofurane, tetrahydrofurfurylalcohol, tetrahydro naphthalene, toluene, trichloroethane, trichloroethylene, n-tridecane, triethanolamine, triethyleneglycol, triethethyleneglycol monoethylether, triethyleneglycol dimethylether, tripropyleneglycol, hydrogenperoxide, tripropylengylcol monobutylether, tripropyleneglycol monomethylether, n-undecane, xylene, mesitylene, acetophenone, acetaldehyde, butyrolactone, ethylenecarbonate, propylenecarbonate, acetonitrle, butyronitrile, N-ethylpyrrolidone, and mixtures thereof. Mixtures of the aforementioned solvents may further comprise water.

More preferably, the solvent is selected from the group consisting of benzyl alcohol, formic acid, dimethylacetamide, dimethylformamide, cyclohexanone, ethanolamine, triethanolamine, ethyleneglycol monobutylether acetate, ethyleneglycol monoethylether, and mixtures thereof.

Most preferably, the solvent is selected from the group consisting of formic acid, benzyl alcohol, ethyleneglycol monobutylether acetate, ethyleneglycol monoethylether and mixtures thereof.

The temporary resin layer (104) is contacted with the solvent by immersion, spraying, or dipping. For stripping purpose, the solvent is held at a temperature in the range of 5 to 100 °C, more preferably 10 to 90 °C and most preferably 15 to 80 °C. The contact time during stripping ranges from 1 to 600 seconds, more preferably from 10 to 540 seconds and most preferably from 20 to 480 seconds. During stripping, the permanent resin layer (104) is not damaged.

At least one contact area opening (105) is formed in the next step (Fig. 2 c). The contact area opening (105) extends through the temporary resin layer (104) and the permanent resin layer (103) and exposes a contact pad (101). Methods suitable to form said contact area opening (105) are for example laser drilling, plasma etching, spark erosion and mechanical drilling. Material from both the permanent resin layer (103) and the temporary resin layer (104) are removed in a single step in order to form a contact area opening (105).

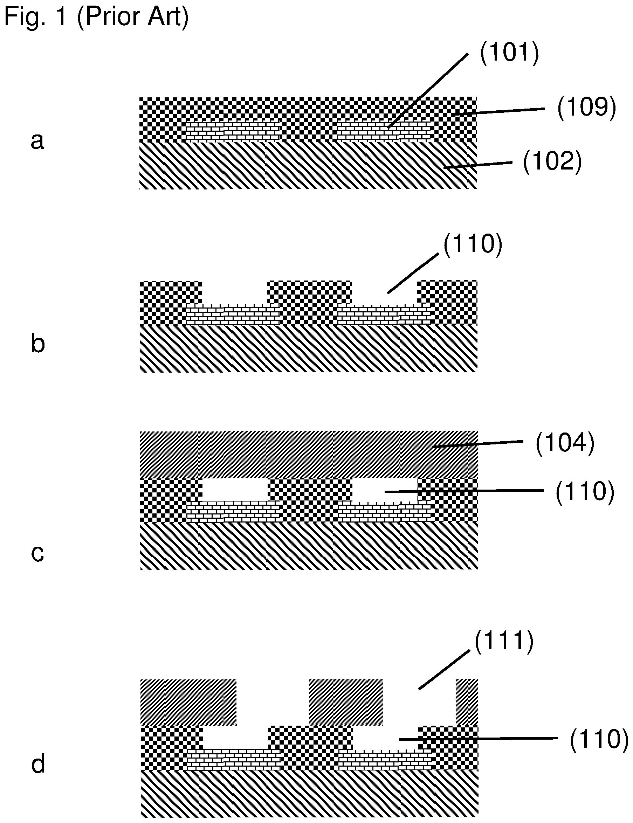

The main advantage of said "multi layer drilling" method is that no misalignment of the openings in the permanent resin layer (103) and the temporary resin layer (104) can occur. Such misalignment of openings is a severe problem, especially for opening diameters of ≤ 150 µm, when applying methods known on the art. In known methods the contact pad openings are formed in two separate steps (Fig. 1). A first solder resist opening (110) is formed in the permanent resin layer (103) which can be a solder resist layer (109), by methods such as photo structuring, drilling or screen printing (Fig. 1 b). Next, a temporary resin layer (104) is attached (Fig. 1 c) and temporary resin openings (111) are formed in a second photo structuring method, by drilling or screen printing (Fig. 1 d). A contact area opening (105) consists then of a solder resin opening (110) and a temporary resin layer opening (111) which are misaligned.

In order to fabricate a metal or metal alloy layer (107) by electroplating on a non-conductive surface (102), a conductive seed layer formed on the non-conductive surface is required to initiate the electroplating. Such a first conductive seed layer (106) is depicted in Fig. 2d. The seed layer is for example formed by electroless deposition in the conventional manufacturing of non-conductive surfaces and is well known in the art.

According to the present invention the first conductive seed layer (106) is deposited over the entire surface of the non-conductive substrate (102) including the at least one contact area (101), the permanent resin layer (103) and the temporary resin layer (104) (Fig. 2 d).

The non-conductive substrates can be activated by various methods which are described, for example, in Printed Circuits Handbook, C. F. Coombs Jr. (Ed.), 6th Edition, McGraw Hill, pages 28.5 to 28.9 and 30.1 to 30.11. These processes involve the formation of a conductive layer comprising carbon particles, Pd colloids or conductive polymers.

Some of these processes are described in the patent literature and examples are given below:
European patent EP 0 616 053 describes a process for applying a metal coating to a non-conductive substrate (without an electroless coating) comprising:
a. contacting said substrate with an activator comprising a noble metal/Group IVA metal sol to obtain a treated substrate;
b. contacting said treated substrate with a self accelerating and replenishing immersion metal composition having a pH above 11 to pH 13 comprising a solution of;
   (i) a Cu(II), Ag, Au or Ni soluble metal salt or mixtures thereof,
   (ii) a Group IA metal hydroxide,
   (iii) a complexing agent comprising an organic material having a cumulative formation constant log K of from 0.73 to 21.95 for an ion of the metal of said metal salt.

This process results in a thin conductive layer which can be used for subsequent electroplating. This process is known in the art as the "Connect" process.

US 5,503,877 describes the metallisation of non-conductive substrates involving the use of complex compounds for the generation of metal seeds on a non-metallic substrate. These metal seeds provide for sufficient conductivity for subsequent electroplating. This process is known in the art as the so-called "Neo-ganth" process.

US 5,693,209 relates to a process for metallisation of a non-conductive substrate involving the use of conductive pyrrole polymers. The process is known in the art as the "Compact CP" process.

EP 1 390 568 B1 also relates to direct electrolytic metallisation of non-conductive substrates. It involves the use of conductive polymers to obtain a conductive layer for subsequent electrocoating. The conductive polymers have thiophene units. The process is known in the art as the "Seleo CP" process.

Finally, the non-conductive substrate can also be activated with a colloidal or an ionogenic palladium ion containing solution, methods for which are described, for example, in Printed Circuits Handbook, C. F. Coombs Jr. (Ed.), 6th Edition, McGraw Hill, pages 28.9 and 30.2 to 30.3.

Subsequent electroless plating of a thin intermediate metal coating can optionally been carried out in order to enhance the first conductive seed layer (106). With assistance of the seed layer, electroplating of the metal or metal alloy layer (107) according to the present invention can then be carried out.

According to the present invention, said first conductive seed layer (106) may be made of a single metal layer, a single metal alloy layer or made of multilayer of at least two distinct single layers. Metals and metal alloys suitable as conductive seed layer are selected from the group consisting of copper, tin, cobalt, nickel, silver, tin-lead alloy, tin-silver alloy, copper-nickel alloy, copper-chromium alloy, copper-ruthenium alloy, copper-rhodium alloy, copper-silver alloy, copper-iridium alloy, copper-palladium alloy, copper-platinum alloy, copper-gold alloy and copper-rare earth alloy, copper-nickel-silver alloy, copper-nickel-rare earth metal alloy. Copper and copper alloys selected from the group consisting of copper-nickel alloys, copper-ruthenium alloys and copper-rhodium alloys are most preferred as a first conductive seed layer (106).

In accordance with a preferred embodiment of the present invention, said first conductive seed layer (106) can also be formed by an electroless plating method, wherein the catalytic metal does not use noble metal but uses copper as the catalytic metal. The typical examples for forming such a catalytic copper on a non-conductive surface can be found in the US 3,993,491 and US 3,993,848.

The thickness of said first conductive seed layer (106) preferably is less than 0.1 millimeter and more preferably between 0.0001 millimeter and 0.005 millimeter. Depending on the solubility of said first conductive seed layer (106) in the metal or metal alloy layer (107), said first seed layer (106) can either completely dissolve into the metal or metal alloy layer (107) or still at least partially exist after the reflow process.

Optionally, a layer of silver or a silver alloy is plated onto the metal or metal alloy layer (107) as a protection layer (117).

In case the metal or metal alloy layer (107) is a tin or tin alloy layer, a reflowed solder deposit (108) or a non-melting bump structure (112) can be obtained from layer (107) depending on the thickness of the first conductive seed layer (106) and the amount of first conductive seed layer (106) dissolved in the metal or metal alloy layer (107) when reflowing.

A reflowed solder deposit (108) is obtained from a metal or metal alloy layer (107) consisting of tin or a tin alloy having a melting point of less than 250 °C when reflowing.

A non-melting bump structure (112) is obtained from either a metal or metal alloy layer (107) consisting of a tin alloy layer having a melting point of more than 250 °C when reflowing or from a copper or a copper alloy deposited as the metal or metal alloy layer (107).

A thinner first conductive seed layer (106) is preferred, since a thinner seed layer can be removed sooner in the etching solution, the time required for said non-conductive substrate (102) immersed in an etching solution could be shortened. In such a case, the damages to said temporary resin layer (104) by said etching solution will be lowered down to an acceptable low level.

Referring now to Fig. 2 e: a metal or metal alloy layer (107) containing a metal or metal alloy selected from the group consisting of tin, copper, tin alloy and copper alloy is then formed on the first conductive seed layer (106) by electroplating.

In accordance with a preferred embodiment of the present invention, said metal or metal alloy layer (107) is selected from the group consisting of tin, copper, a tin alloy made by the mixture of tin and the elements selected from the group consisting of lead, silver, copper, bismuth, antimony, zinc, nickel, aluminium, magnesium, indium, tellurium, gallium and rare earth elements, and a copper alloy with the at least one alloying element selected from the group consisting of vanadium, chromium, manganese, iron, cobalt, nickel, zink, germanium, selenium, rhodium, palladium, silver, cadmium, indium, tin, antimony, tungsten, rhenium, iridium, platinum, gold, lead, bismuth, thallium and rare earth elements

Tin and tin alloy plating baths are known in the art. Commonly used tin or tin alloy plating bath compositions and process parameters for plating are described in the following.

Among other components of the tin or tin alloy bath may be added a source of Sn²⁺ ions, an anti-oxidant, and a surfactant.

The source of Sn²⁺ ions may be a soluble tin-containing anode, or, where an insoluble anode is used, a soluble Sn²⁺ ion source. Tin methane sulfonic acid, Sn(MSA)₂, is a preferred source of Sn²⁺ ions because of its high solubility. Typically, the concentration of the source of Sn²⁺ ions is sufficient to provide between about 10 g/l and about 100 g/l of Sn²⁺ ions into the bath, preferably between about 15 g/l and about 95 g/l, more preferably between about 40 g/l and about 60 g/l. For example, Sn(MSA)₂ may be added to provide between about 30 g/l and about 60 g/l Sn²⁺ ions to the plating bath.

A preferred tin alloy is tin silver alloy. In such case the plating bath additionally contains a soluble silver salt, commonly used are nitrate, acetate, and preferably methane sulfonate. Typically, the concentration of the source of Ag⁺ ions is sufficient to provide between about 0.1 g/l and about 1.5 g/l of Ag⁺ ions into the bath, preferably between about 0.3 g/l and about 0.7 g/l, more preferably between about 0.4 g/l and about 0.6 g/l. For example, Ag(MSA) may be added to provide between about 0.2 g/l and about 1.0 g/l Ag⁺ ions to the plating bath.

Anti-oxidants may be added to the baths of the present invention to stabilize the bath against oxidation of Sn²⁺ ions in solution. Preferred anti-oxidants such as hydroquinone, catechol, and any of the hydroxyl, dihydroxyl, or trihydroxyl benzoic acids may be added in a concentration between about 0.1 g/l and about 10 g/l, preferably between about 0.5 g/l and about 3 g/l. For example, hydroquinone may be added to the bath at a concentration of about 2 g/l.

Surfactants may be added to promote wetting of the substrate. The surfactant seems to serve as a mild deposition inhibitor which can suppress three-dimensional growth to an extent, thereby improving morphology and topography of the film. It can also help to refine the grain size, which yields a more uniform bump. Exemplary anionic surfactants include alkyl phosphonates, alkyl ether phosphates, alkyl sulfates, alkyl ether sulfates, alkyl sulfonates, alkyl ether sulfonates, carboxylic acid ethers, carboxylic acid esters, alkyl aryl sulfonates, aryl alkylether sulfonates, aryl sulfonates, and sulfosuccinates.

The electrolytic tin or tin alloy plating bath of the present invention preferably has an acidic pH to inhibit anodic passivation, achieve better cathodic efficiency, and achieve a more ductile deposit. Accordingly, the bath pH is preferably between about 0 and about 3. In the preferred embodiment the pH of the bath is 0. Accordingly, the preferred acidic pH can be achieved using nitric acid, acetic acid, and methane sulfonic acid. In one preferred embodiment, the acid is methane sulfonic acid. The concentration of the acid is preferably between about 50 g/l and about 200 g/l, more preferably between about 70 g/l and about 120 g/l. For example, between about 50 g/l and about 160 g/l methane sulfonic acid can be added to the electroplating bath to achieve a bath of pH 0 and act as the conductive electrolyte.

Typical tin or tin alloy bath compositions are for example disclosed in: Jordan: The Electrodeposition of Tin and its Alloys, 1995, p. 71-84.

The plating of tin and tin alloys for solder depot plating can be performed by direct current (DC) or pulse plating. The advantages of pulse plating are better surface distribution uniformity and improved crystal structures with tin deposits possessing finer grain sizes and therefore better solderability properties. Also, higher applicable current density and therefore higher throughput can be obtained by pulse plating compared to DC plating.

Generally, current pulses at an effective current density of 1 - 20 A/dm² can be applied. Alternatively, operating of the bath with DC at a current density of 1 - 3 A/dm² can be performed.

For example, applying a tin pulse plating with a current density of 3 A/dm² yields an average thickness of the tin deposit of 40 µm within 30 min. plating time. The thickness variation on the surface is only +/- 15%. Applying DC plating a maximum current density of only 1 A/dm² can be obtained. Plating time to obtain a thickness of the tin deposit of 40 µm is 86 min. The variation on the surface is +/- 33%, thus much higher than for pulse plating.

Preferred pulse parameters are as follows:
The ratio of the duration of the at least one forward current pulse to the duration of the at least one reverse current pulse is adjusted to at least 1 : 0 - 1 : 7, preferably to at least 1 : 0.5 - 1 : 4 and more preferably to at least 1 : 1 - 1 : 2.5.

The duration of the at least one forward current pulse can be adjusted to preferably at least 5 ms to 1000 ms.

The duration of the at least one reverse current pulse is preferably adjusted to 0.2 - 5 ms at most and most preferably to 0.5 - 1.5 ms.

The peak current density of the at least one forward current pulse at the workpiece is preferably adjusted to a value of 1 - 30 A/dm² at most. Particularly preferable is a peak current density of the at least one forward current pulse at the workpiece of about 2 - 8 A/dm² in horizontal processes. In vertical processes the most preferred peak current density of the at least one forward current pulse at the workpiece is 1 - 5 A/dm² at most.

The peak current density of the at least one reverse current pulse at the work piece will preferably be adjusted to a value of 0 - 60 A/dm². Particularly preferred is a peak current density of the at least one reverse current pulse at the workpiece of about 0 - 20 A/dm² in horizontal processes. In vertical processes the most preferred peak current density of the at least one forward current pulse at the workpiece is 0 - 12 A/dm² at most.

Copper and copper alloy plating baths are known in the art. Commonly used copper or copper alloy plating bath compositions and process parameters for plating can be applied.

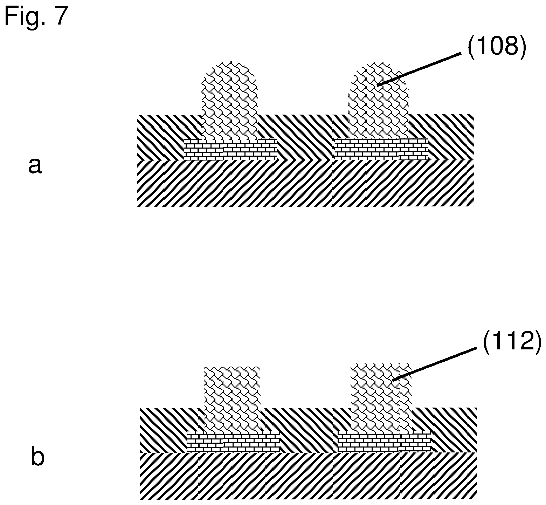

In a preferred embodiment of the present invention said first conductive seed layer (106) is made of copper and the metal or metal alloy layer (107) consists of tin or a tin alloy. During reflow operations said first conductive seed layer (106) is completely dissolved into the tin layer (107) forming a reflowed solder deposit layer (108) which consists of a homogeneous tin-copper alloy (Fig. 7 a). The target thickness of the first conductive seed layer (106) can be adjusted depending on the volume of the tin layer (107) in order to obtain a tin-copper alloy after reflow which resembles that of typical lead-free solder materials, e.g., a tin-copper alloy with 0.7 wt.-% copper.

In case of a higher thickness of a first conductive seed layer (106) made of copper, dissolution of said conductive seed layer into the tin layer (107) leads to a tin-copper alloy having a melting point above 250 °C. Such a tin-copper alloy is a non-melting bump structure (112) (Fig. 7 b). Copper or a copper alloy as metal or metal alloy layer (107) also resembles a non-melting bump-structure (112).

In another preferred embodiment of the present invention said first conductive seed layer (106) consists of copper or a copper alloy and the metal or metal alloy layer (107) consists of copper. This combination also leads to a non-melting bump structure (112) (melting point above 250 °C).

The openings in the structures according to the Fig. 2 are denoted contact area openings (105) and preferably have a diameter of about 5 - 1.000 µm, more preferred of about 10 - 500 µm and most preferred 20 - 150 µm.

The height of the contact area openings (105) varies between 5 - 250 µm, preferably of about 10 - 60 µm. The distance of the center points of adjacent contacts areas is denoted as pitch and ranges from 20 - 150 µm for IC substrates, and from 150 - 1.000 µm for printed circuits.

Since also the temporary resin layer (104) is covered by a first conductive seed layer (106) plating of the metal or metal alloy layer (107) is also on this layer. The thickness of such a metal or metal alloy layer (107) should preferably not exceed 10 µm and more preferred not exceed 6 µm on top of the temporary resin layer (104).

While this process sequence has been described in detail for a substrate according to Fig. 2 it is not limited to such and may be applied to all kind of substrates.

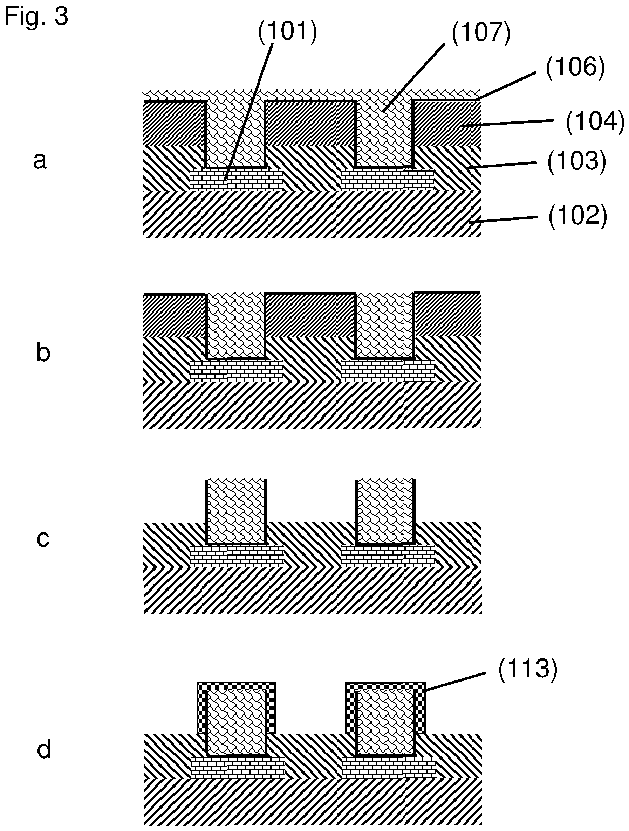

One method for depositing a solderable cap layer (113) or a barrier layer onto the top of the metal or metal alloy layer (107) - not related to the invention - comprises deposition of a solderable cap layer (113) or a barrier layer directly after removal of the temporary resin layer (104) (Fig. 3). The solderably cap layer (113) or the barrier layer is deposited by electroless plating of tin or a tin alloy which comprises immersion-type plating and autocatalytic plating. The resulting solderable cap layer (113) or barrier layer may be deposited not only on top of the metal or metal alloy layer (107) but also on the side walls of the metal or metal alloy layer (107) which are exposed after removal of the temporary resin layer (104) (Fig. 3 d).

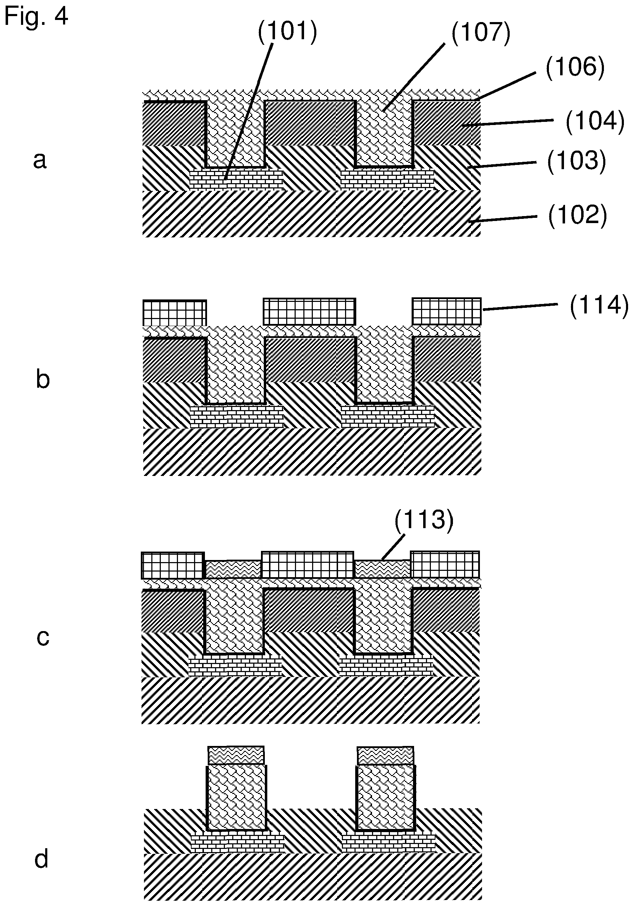

Another method for depositing a solderable cap layer (113) or a barrier layer onto the top surface of a non-melting bump structure (112) is shown in Figure 4: A substrate obtained by the method according to claim 1 is provided (Fig. 4 a).

A resist layer (114) is deposited onto the surface of the substrate and patterned. The top surface of the metal or metal alloy layer (107) is then exposed (Fig. 4 b).

Next, a layer of a metal or metal alloy selected from the group consisting of tin, nickel, chromium, titanium, silver, gold, palladium, alloys thereof and multi layers thereof is deposited into the openings formed by the patterned resist layer (114) (Fig. 4 c). If said layer consists of tin or tin alloy it has the function of a solderable cap layer (113). In case the layer consists of nickel, chromium, titanium, silver, gold, palladium, alloys thereof and multi layers thereof the layer has the function of a barrier layer.

The patterned resist layer (114) is stripped by methods known in the art. The conductive seed layer (106) on top of the temporary resin layer (104) and the metal or metal alloy layer (107) are removed from the first conductive seed layer (106) (Fig. 4 d). No additional etch resist is applied onto the metal or metal alloy layer (107) above the at least one contact area (101) prior to removal of the metal or metal alloy layer (107) and the first conductive seed layer (106).

The term "etch resist" is defined herein as any kind of patterned barrier, e.g., photo imageable or screen printed organic resists and metal etch resists which prevents undesired removal of material beneath said etch resist during etching.

The removal preferably is performed by chemical etching an amount of the metal or metal alloy layer (107) sufficient to remove the metal or metal alloy layer (107) from the first conductive seed layer (106) leaving a metal or metal alloy layer (107) on the at least one contact area (101) in the openings (105).

In case the metal or metal alloy layer (107) consists of tin and tin alloys the etching can be performed electrolytically or chemically. Also, mechanical polishing may be applied alone or in combination with electrolytical or chemical stripping to remove the metal or metal alloy layer (107).

Typical etching or stripping compositions for metal or metal alloy layers (107) consisting of tin or tin alloys are for example disclosed in: Jordan: The Electrodeposition of Tin and its Alloys, 1995, p. 373-377.

During electrolytic stripping methods tin or its alloys are anodically dissolved in a 10 wt.-% NaOH solution at 70 - 90 °C.

Chemical stripping generally is performed in solutions containing a strong base like NaOH (about 10 wt.-%) at elevated temperatures of 70 - 90 °C. Organic additives, particularly nitroaromtic compounds like p-nitrophenol, may be added to the solution.

Alternatively, chemical stripping can be performed in the following solutions:
- hydrogen peroxide, often with added fluoride,
- systems based on nitric acid and nitrates, 5 - 40 wt.-% of nitrate,
- systems based on HCI / copper chloride, containing 5 - 20 wt.-% HCI with an initial concentration of 2.5 mg/l copper chloride.

In case the metal or metal alloy layer (107) consists of copper and copper alloys the etching can be performed electrolytically or chemically. Also, mechanical polishing may be applied alone or in combination with electrolytical or chemical stripping to remove the metal or metal alloy layer (107).

Typical etching or stripping compositions for metal or metal alloy layers (107) consisting of copper or copper alloys and a first conductive seed layer (106) consisting of copper or a copper alloy are for example disclosed in: C. F. Coombs, Jr, "Printed Circuits Handbook", 5th Ed. 2001, McGraw-Hill, Chapter 33.4.

Suitable etching solutions and etching conditions are chosen in routing experiments.

Optionally, a layer of silver or a silver alloy is plated onto the solderable cap layer (113) as a protection layer (117).

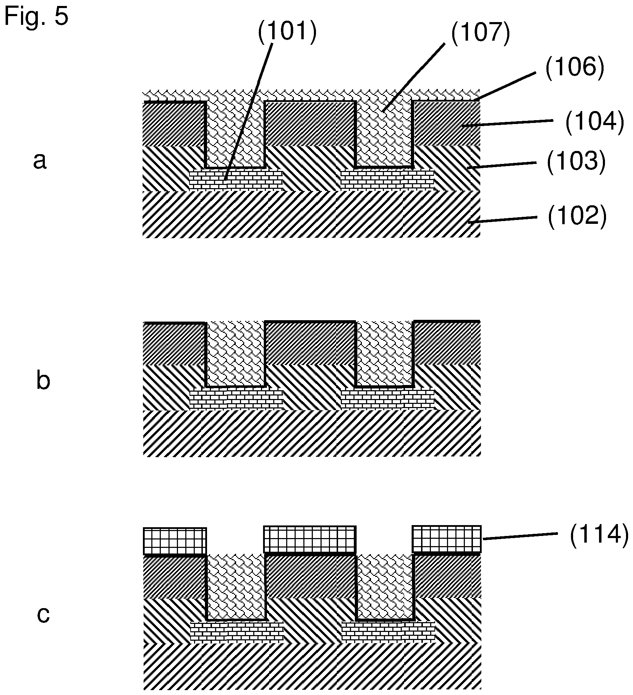

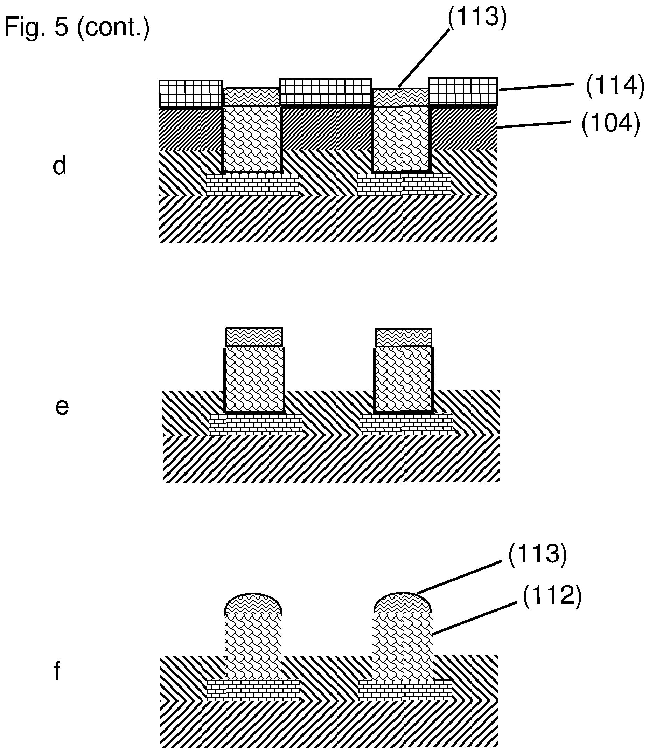

Still another method for depositing a solderable cap layer (113) or a barrier layer (115) onto the top surface of a non-melting bump structure (112) - not related to the invention - is shown in Figure 5:
A substrate obtained by the method according to claim 1 is provided (Fig. 5 a).

The metal or metal alloy layer (107) is removed from the first conductive seed layer (106) by etching without use of an etch resist (Fig. 5 b). Only those portions of the metal or metal alloy layer (107) which are plated into openings (105) remain.

A resist layer (114) is deposited onto the surface of the substrate and patterned. The top surface of the metal or metal alloy layer (107) is exposed (Fig. 5 c).

Next, a layer of a metal or metal alloy selected from the group consisting of tin, nickel, chromium, titanium, silver, gold, palladium, alloys thereof and multi layers thereof is deposited into the openings formed by the patterned resist layer (114) (Fig. 5 d). If said layer consists of tin or tin alloy it has the function of a solderable cap layer (113). In case the layer consists of nickel, chromium, titanium, silver, gold, palladium, alloys thereof and multi layers thereof the layer has the function of a barrier layer.

The patterned resist layer (114) is stripped by methods known in the art. The conductive seed layer (106) on top of the temporary resin layer (104) is removed as described above, followed by stripping of the temporary resin layer (104) (Fig. 5 e).

The non-melting bump structure (112) has now a solderable cap layer (113) or a barrier layer on the top surface. Figure 5 f shows the non-melting bump structures (112) and the solderable cap layer (113) after reflowing.Optionally, a layer of silver or a silver alloy is plated onto the solderable cap layer (113) as a protection layer (117) prior to reflowing.

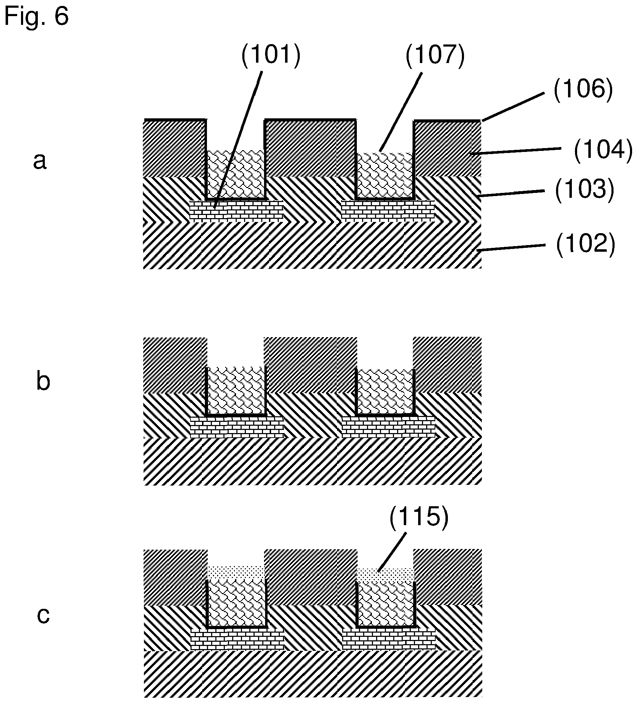

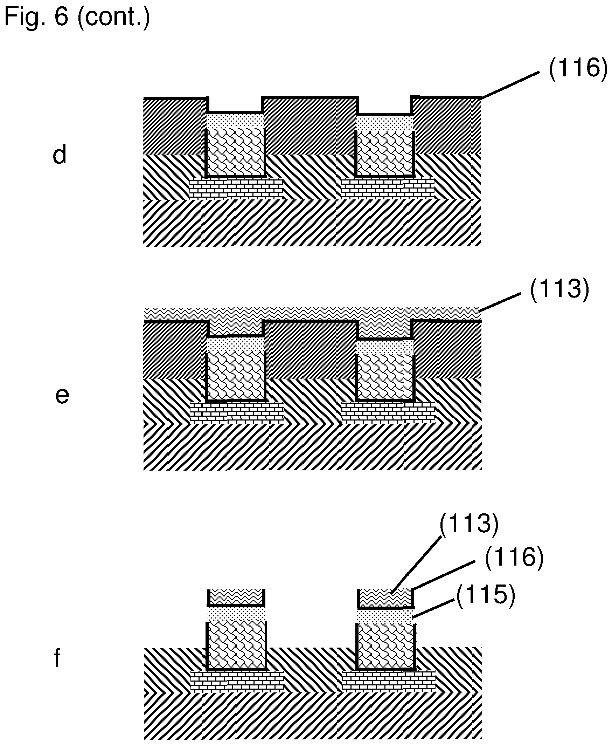

Still another method for depositing a solderable cap layer (113) onto the top surface of a non-melting bump structure (112) - not related to the invention - is shown in Figure 6:
Disclosed is a substrate according to Fig. 6 a.

The first conductive seed layer (106) is removed by etching (Fig. 6 b). Typical etching or stripping compositions for the first conductive seed layer (106) consisting of copper or a copper alloy are for example disclosed in: C. F. Coombs, Jr, "Printed Circuits Handbook", 5th Ed. 2001, McGraw-Hill, Chapter 33.4.

Next, a barrier layer (115) is deposited onto the top of the metal or metal alloy layer (107) (Fig. 6 c). The barrier layer (115) can be an adhesive layer of nickel, nickel alloys and/or a protective layer of gold. Said barrier layer (115) may also be made of nickel, chromium, titanium, silver, gold, palladium, alloys thereof and multi layers thereof which can be made by electroless plating, physical vapor deposition or chemical vapour deposition.

A second conductive seed layer (116) is deposited onto the outer surface of the temporary resin layer (104) and the barrier layer (115) (Fig. 6 d). The same kind of materials and deposition methods as discussed for the first conductive seed layer (106) apply to the second conductive seed layer (116).

Next, a layer of tin or a tin alloy serving later as the solderable cap layer (113) is deposited onto the second conductive seed layer (116) (Fig. 6 e).

Thereafter, the solderable cap layer (113) is removed from those portions of the second conductive seed layer (116) which are on top of the temporary resin layer (104). No additional etch resist is applied onto the solderable cap layer (113) above the at least one contact area (101) prior to removal of the solderable cap layer (113) and from the outer surface of the second conductive seed layer (116). Also removed are the second conductive seed layer (116) and the temporary resin layer (104) leaving the bump structures comprising a non-melding bump, a barrier layer (115) and the solderable cap layer (113) (Fig. 6f).

Optionally a layer of silver or a silver alloy is plated onto the solderable cap layer (113) as a protection layer (117). The following example further illustrates the present invention.

At a reflow temperature, either a reflowed solder deposit (108) (Fig. 7 a) or a non-melting bump structure (112) (Fig. 7 b) can be formed from the metal or metal layer (107). A metal or metal alloy layer (107) which leads to reflowed solder deposit (108) has a melting point of less than 250 °C whereas a metal or metal alloy layer (107) which leads to a non-melting bump structure (112) at a reflow temperature has a melting point of more than 250 °C.

In accordance with a preferred embodiment of the present invention, reflowed solder deposits (108) can be formed by further removing the first conductive seed layer (106) from the temporary resin layer (104) and stripping the temporary resin layer (104). Such reflowed solder deposits (Fig. 7 a) can be applied for forming flip chip joints and board to board solder joints.

The reflowed solder deposits (108) can be any shape, such as stud bumps, ball bumps, columnar bumps, or others.

Non-melting bump structures (112) are manufactured with the same method as applied for the manufacture of reflowed solder deposits (108). During reflowing the conductive seed layer can be dissolved partially or completely in the non-melting bump structure (112) (Figure 7 b). This depends on the seed layer thickness and its composition, and the duration of the applied temperature. In case of a partial dissolved seed layer the centre of the bump would have a lower melting point as the, by diffusion formed, higher melting temperature barrel. Such a non-melting bump structure is capable to withstand minimum one reflow cycle to support sufficient standoff height for subsequent cleaning and underfill processes.

Non-melting bump structures (112) can be used for forming flip chip joints and board to board solder joints with or without depositing a solderable cap layer (113). In case of a solderable cap layer this would be done preferably by electroplating a solderable cap layer (113) on the top surface of said non-melting bump structure (112).

A barrier layer on top of a non-melting bump structure (112) prevents solder material from diffusing into the non-melting bump structure (112) during soldering and thereby maintains the thermal and mechanical properties of the non-melting bump structure (112).

### Examples

### Example 1

An IC substrate is used having a contact pad structure according to Fig. 2 a.

The non-conductive substrate (102) consists of GX-13 material (manufacturer: Ajinomoto Fine-Techno Co., Inc.), the permanent resin layer (103) consists of GX-92 material (manufacturer: Ajinomoto Fine-Techno Co., Inc., height of the layer: 25 µm) and the contact pads consist of copper.

A temporary resin layer (104) (DuPont PM 200, height: 50 µm) was laminated onto the permanent resin layer (103).

Next, contact area openings (105) are formed through the temporary resin layer (104) and the permanent resin layer (103) with a UV laser in one step. The diameter of the contact area openings (105) is 100 µm.

The plating sequence is according to Fig. 2 d to e. First, a first conductive seed layer (106) of copper is formed on the entire substrate surface. For this the surface is first contacted with an acidic solution containing ionogenic palladium and then with a solution for electroless copper deposition.

Thereafter, a tin layer (107) is plated on the conductive layer from a bath containing:
45 g/L Sn²⁺ as Sn(MSA)₂, 60 mL/L MSA (70% solution), 2 g/L Hydroquinone and 100 mg/L benzal acetone.

The pH of the bath is 0, the temperature 25 °C. Plating is for 15 min. Standard DC plating with a current density of 1 A/dm² is applied.

The contact area openings (105) according to Fig. 2 d are completely filled with tin solder deposit without any void formation. Additionally, tin has been deposited on the temporary resin layer (104) area, the thickness of which is 3 µm (Fig. 2 e).

The tin layer (107) on the temporary resin layer (104) area as well as the first conductive seed layer (106) are directly thereafter removed by treatment in a solution containing 30 vol.-% nitric acid at a temperature of 40 °C for 1 min.

After the etching process tin layer (107) only remains in the opening, while the tin layer (107) as well as the first conductive seed layer of copper (106) on the temporary resin layer (104) area have been entirely removed. Next, the temporary resin layer (104) is removed by immersing the substrate in an aqueous solution of 2 wt.-% potassium carbonate. The tin layer, i.e. the solder deposit shows a very homogenous surface distribution and is whisker free. It is suited to be soldered to a chip or circuit.

### Example 2

A non-melting bump structure (112) consisting of a tin-copper alloy with a solderable cap layer (113) made of tin was manufactured. An IC substrate is used having at least one contact area structure according to Fig. 2 a.

The non-conducting substrate (102) consists of GX-13 material (manufacturer: Ajinomoto Fine-Techno Co., Inc.), the permanent resin layer (103) consists of GX-92 material (manufacturer: Ajinomoto Fine-Techno Co., Inc., height of the layer: 25 µm) and the contact pads (101) consist of copper.

A temporary resin layer (104) (DuPont PM 200, height: 50 µm) was laminated onto the permanent resin layer (103).

Next, contact area openings (105) are formed through the temporary resin layer (104) and the permanent resin layer (103) with a UV laser in one step. The diameter of the contact area openings (105) is 100 µm.

The plating sequence is according to Fig. 2 d to e. A first conductive seed layer (106) of copper is formed on the entire substrate surface. For this the surface is first contacted with an acidic solution containing ionogenic palladium and then with a solution for electroless copper deposition. The thickness of the first conductive seed layer (106) in the opening (105) is sufficient to form a tin-copper alloy with the tin layer (107) during reflow operations. The resulting tin-copper alloy has a melting point above 250 °C and hence serves as a non-melting bump (112).

Thereafter, a tin layer (107) is plated on the first conductive seed layer (106) from a bath containing:
45 g/l Sn²⁺ as Sn(MSA)₂, 60 ml/l MSA (70 wt.-% solution), 2 g/l Hydroquinone, a surfactant based on co-polymers and 100 mg/l benzal acetone.

The pH of the bath is 0, the temperature 25 °C. Plating is for 15 min. Standard DC plating with a current density of 1 A/dm² is applied.

The contact area openings (105) according to Fig. 2 d are completely filled with tin solder deposit without any void formation. Additionally, tin has been deposited on the temporary resin layer (104) area, the thickness of which is 3 µm (Fig. 2 e).

The tin layer (107) on the first conductive seed layer (106) is thereafter removed by treatment in a solution containing 30 vol.-% nitric acid at a temperature of 40 °C for 1 min. No etch resist is applied. After the etching process the tin layer (107) only remains in the opening (105).

The resist layer (114) is removed in a stripping solution followed by etching away of the first conductive seed layer (106).

Next, the temporary resin layer (104) is removed by immersing the substrate in a stripping solution. The tin solder deposit shows a very homogenous surface distribution and is whisker free. It is suited to be soldered to a chip or circuit.

### Example 3

A non-melting bump structure (112) consisting of copper with a solderable cap layer (113) made of tin was manufactured.

An IC substrate comprising a non-conductive substrate (102), contact areas (101), a permanent resin layer (103) and a temporary resin layer (104) as used in Example 1 is provided.

Contact area openings (105) are formed through the temporary resin layer (104) and the permanent resin layer (103) with a UV laser in one step. The diameter of the contact area openings (105) is 100 µm. The plating sequence is according to Fig. 2 d to e. A first conductive seed layer (106) of copper is formed on the entire substrate surface. For this the surface is first contacted with an acidic solution containing ionogenic palladium and then with a solution for electroless copper deposition.

Thereafter, a copper layer (107) is electroplated onto the first conductive seed layer (106) from a bath containing: 45 g/l Cu²⁺ as CuSO₄, 50 ml/l H₂SO₄, 1 ml/l brightener and 20 ml/l leveler additive. The pH of the bath is 0, the temperature 25 °C. Plating is for 45 min. Standard pulse parameters with a average current density of 4 A/dm² is applied.

The contact area openings (105) according to Fig. 2 c are completely filled with a copper deposit without any void formation. Additionally, copper has been deposited on the temporary resin layer (104) area, the thickness of which is <15 µm (Fig. 2 e).

Thereafter a resist layer (114) (DuPont PM 200) is laminated onto the copper layer (107) and patterned

Next, tin is electroplated from a plating bath composition comprising 45 g/l Sn²⁺ as Sn(MSA)₂, 60 ml/l MSA (70 wt.-% solution), 2 g/l Hydroquinone, a surfactant based on co-polymers and 100 mg/ benzal acetone to form a solderable low melting cap layer (113).

The resist layer (114) is stripped off in a standard dry film resist stripping solution.

The first conductive seed layer (106) and the copper layer (107) deposited onto the surface of the temporary resin layer (104) are thereafter removed from the surface of the temporary resin layer (104) by treatment in a solution containing 30 vol.-% nitric acid at a temperature of 40 °C for 1 min.

Next, the temporary resin layer (104) is removed by immersing the substrate in a stripping solution again.

The non melting pump and the solder cap deposit shows a very homogenous surface distribution and is whisker free. It is suited to be soldered to a chip or circuit with a sufficient stand off height.

### Preparation of resin materials suitable as temporary resin layer (104)

An amount of 32 g of an acrylic resin with a Tg of 53 °C as measured according to ISO11357-1 and a viscosity number of 33 measured according to ISO1628-1 is dissolved in 45 g of a solvent which is suitable for screen printing formulations and having a boiling point of 180-200 °C, under stirring (500-700 rpm) and heating at 80 °C. When the solution has reached 80 °C, 15 g of a layered filler and silicon containing additives are added which are needed to make the liquid formulation thixotropic and therefore suitable for screen printing applications. The mixture is stirred for 10 min and milled over a triple roll mill. The formulation thus obtained is screen printed on the permanent resin layer (103) and dried in a convection oven (Koenig hardness after drying: 100 s). The coating thus obtained can be dipped into an acidic solution (2.5 % hydrochloric acid at 50 °C, pH < 1) for 5 minutes without damages. In the same way, it can be dipped into an alkaline solution (3 % sodium hydroxide, 50 °C, pH < 13) with no damages. After both treatment in acid or base, the coating can be fully removed from the substrate by treatment with dimethylacetamide (50 °C, 4 minutes). The permanent resin layer (103) beneath is not attacked under those conditions.

## Claims

1. A method of forming a solder deposit on a substrate comprising the following steps:
i) provide a substrate (102) including at least one contact area (101) and at least one permanent resin layer (103) overlying said at least one contact area (101) and at least one temporary resin layer (104) overlying said permanent resin layer (103),
ii) form at least one contact area opening (105) which extends through the temporary resin layer (104) and the permanent resin layer (103),
iii) contact the entire substrate (102) including the permanent resin layer (103), the temporary resin layer (104) and the at least one contact area (101) with a solution suitable to provide a first conductive seed layer (106) on the substrate surface,
iv) electroplate a metal or metal alloy layer (107) onto the first conductive seed layer (106) wherein the metal or metal alloy layer (107) is selected from the group consisting of tin, copper, tin alloys and copper alloys,
**characterised by** the steps:
v) deposit a resist layer (114) onto the metal or metal alloy layer (107) and pattern said resist layer (114) to form openings exposing the metal or metal alloy layer (107) plated into the at least one contact area opening (105),
vi) deposit a solderable cap layer (113) into the openings formed by the resist layer (114),
vii) strip the patterned resist layer (114) by methods known in the art and
(viii) etch away directly after step vii) an amount of the metal or metal alloy layer (107) sufficient to remove the metal or metal alloy layer (107) from the first conductive seed layer (106) leaving a metal or metal alloy layer (107) in the at least one contact area opening (105).

2. Method according to claim 1 wherein the metal or metal alloy layer (107) is selected from the group consisting of copper and copper alloys.

3. Method according to claims 1 or 2 wherein the solderable cap layer (113) is selected from the group consisting of tin and tin alloys.

4. Method according to any of the foregoing claims wherein a first barrier layer is plated on the at least one contact area (101).

5. Method according to any of the foregoing claims wherein the barrier layer consists of a metal or alloy selected from the group consisting of nickel, tin, chromium, titanium, silver, gold, palladium, alloys thereof and multi layers thereof.

6. Method according to any of the foregoing claims wherein the temporary resin layer (104) comprises one or more of acrylates, ethylene/ethylacrylate copolymer, ethylene/methacrylate copolymer, ethylene/acrylic acid copolymer, ethylene/butylacrylate copolymer, polymethylpentene and polymethylmethacrylate.

7. Method according to claim 6 wherein the temporary resin layer (104) further comprises a filler selected from the group consisting of aluminium borate, aluminium oxide, aluminiumtrihydroxide, anthracite, sodium antimonate, antimony pentoxide, antimony trioxide, apatite, attapulgite, barium metaborate, barium sulfate, strontium sulfate, barium titanate, bentonite, beryllium oxide, boron nitride, calcium carbonate, calcium hydroxide, calcium sulfate, carbon black, clay, cristobalite, diatomaceous earth, dolomite, ferrites, feldspar, glass beads, graphite, hydrous calcium silicate, iron oxide, kaolin, lithopone, magnesium oxide, mica, molybdenum disulfide, perlite, polymeric fillers such as PTFE, PE, polyimide, pumice, pyrophyllite, rubber particles, fumed silica, fused silica, precipitated silica, sepiolite, quartz, sand, slate flour, talc, titanium dioxide, vermiculite, wood flour, wollastonite, zeolithes, zinc borate, zinc oxide, zinc stannate, zinc sulfide, aramid fibers, carbon fibers, cellulose fibers, and glass fibers and mixtures thereof.

8. Method according to any of the foregoing claims wherein the at least one contact area (101) comprises a via or a trench.

9. Method according to any of the foregoing claims wherein the first conductive seed layer (106) is formed by electroless deposition of a metal or metal alloy selected from the group consisting of copper, copper-nickel alloys, copper-ruthenium alloys and copper-rhodium alloys.

## Patentansprüche

1. Verfahren zur Herstellung einer Lötmittelabscheidung auf einem Substrat, umfassend folgende Schritte:
i) Bereitstellen eines Substrats (102), das wenigstens einen Kontaktfläche (101), wenigstens eine permanente Harzschicht (103), die über der wenigstens einen Kontaktfläche (101) liegt, und wenigstens eine temporäre Harzschicht (104), die über der permanenten Harzschicht (103) liegt, aufweist,
ii) Bilden wenigstens einer Kontaktflächenöffnung (105), die durch die temporäre Harzschicht (104) und die permanente Harzschicht (103) verläuft,
iii) Inkontaktbringen des gesamten Substrats (102), einschließlich der permanenten Harzschicht (103), der temporären Harzschicht (104) und der wenigstens einen Kontaktfläche (101), mit einer Lösung, die geeignet ist, um eine erste leitfähige Keimschicht (106) auf der Substratoberfläche bereitzustellen,
iv) Elektroplattieren einer Metall- oder Metalllegierungsschicht (107) auf die erste leitfähige Keimschicht (106), wobei die Metall- oder Metalllegierungsschicht (107) ausgewählt ist aus der Gruppe bestehend aus Zinn, Kupfer, Zinnlegierungen und Kupferlegierungen,
**gekennzeichnet durch** die Schritte:
v) Aufbringen einer Resistschicht (114) auf die Metall- oder Metalllegierungsschicht (107) und Strukturieren der Resistschicht (114), um Öffnungen zu bilden, die die Metall- oder Metalllegierungsschicht (107), die in die wenigstens eine Kontaktflächenöffnung (105) plattiert ist, freilegen,
vi) Aufbringen einer lötbaren Deckschicht (113) in die durch die Resistschicht (114) gebildeten Öffnungen,
vii) Entfernen der strukturierten Resistschicht (114) durch auf dem Fachgebiet bekannte Verfahren und
viii) direkt nach Schritt vii) Wegätzen einer ausreichenden Menge der Metall- oder Metalllegierungsschicht (107), um die Metall- oder Metalllegierungsschicht (107) von der ersten leitfähigen Keimschicht (106) zu entfernen, um eine Metall- oder Metalllegierungsschicht (107) in der wenigstens einen Kontaktflächenöffnung (105) zurückzulassen.

2. Verfahren gemäß Anspruch 1, wobei die Metall- oder Metalllegierungsschicht (107) ausgewählt ist aus der Gruppe bestehend aus Kupfer und Kupferlegierungen.

3. Verfahren gemäß Ansprüchen 1 oder 2, wobei die lötbare Deckschicht (113) ausgewählt ist aus der Gruppe bestehend aus Zinn und Zinnlegierungen.

4. Verfahren gemäß einem der vorstehenden Ansprüche, wobei eine erste Sperrschicht auf die wenigstens eine Kontaktfläche (101) plattiert wird.

5. Verfahren gemäß einem der vorstehenden Ansprüche, wobei die Sperrschicht aus einem Metall oder einer Metalllegierung ausgewählt aus der Gruppe bestehend aus Nickel, Zinn, Chrom, Titan, Silber, Gold, Palladium, Legierungen davon und Mehrfachschichten davon besteht.

6. Verfahren gemäß einem der vorstehenden Ansprüche, wobei die temporäre Harzschicht (104) eines oder mehrere von Acrylaten, Ethylen/Ethylacrylat-Copolymer, Ethylen/Methacrylat-Copolymer, Ethylen/Acrylsäure-Copolymer, Ethylen/Butylacrylat-Copolymer, Polymethylpenten und Polymethylmethacrylat umfasst.

7. Verfahren gemäß Anspruch 6, wobei die temporäre Harzschicht (104) ferner einen Füllstoff ausgewählt aus der Gruppe bestehend aus Aluminiumborat, Aluminiumoxid, Aluminiumtrihydroxid, Anthrazit, Natriumantimonat, Antimonpentoxid, Antimontrioxid, Apatit, Attapulgit, Bariummetaborat, Bariumsulfat, Strontiumsulfat, Bariumtitanat, Bentonit, Berylliumoxid, Bornitrid, Calciumcarbonat, Calciumhydroxid, Calciumsulfat, Ruß, Ton, Cristobalit, Diatomeenerde, Dolomit, Ferriten, Feldspat, Glasperlen, Graphit, wasserhaltigem Calciumsilicat, Eisenoxid, Kaolin, Lithopon, Magnesiumoxid, Glimmer, Molybdändisulfid, Perlit, polymeren Füllstoffen, wie z. B. PTFE, PE, Polyimid, Bimsstein, Pyrophyllit, Kautschukpartikeln, pyrogenem Siliciumdioxid, Quarzglas, präzipitiertem Siliciumdioxid, Sepiolit, Quarz, Sand, Schiefermehl, Talkum, Titandioxid, Vermikulit, Holzmehl, Wollastonit, Zeolithen, Zinkborat, Zinkoxid, Zinkstannat, Zinksulfid, Aramidfasern, Kohlenstofffasern, Cellulosefasern und Glasfasern und Gemischen davon.

8. Verfahren gemäß einem der vorstehenden Ansprüche, wobei die wenigstens eine Kontaktfläche (101) eine Durchkontaktierung oder einen Graben umfasst.

9. Verfahren gemäß einem der vorstehenden Ansprüche, wobei die erste leitfähige Keimschicht (106) durch stromlose Abscheidung eines Metalls oder einer Metalllegierung ausgewählt aus der Gruppe bestehend aus Kupfer, Kupfer-Nickel-Legierungen, Kupfer-Ruthenium-Legierungen und Kupfer-RhodiumLegierungen gebildet wird.

## Revendications

1. Procédé de formation d'un dépôt de soudure sur un substrat comprenant les étapes suivantes :
i) mise à disposition d'un substrat (102) comprenant au moins une aire de contact (101) et au moins une couche permanente de résine (103) recouvrant ladite au moins une aire de contact (101) et au moins une couche temporaire de résine (104) recouvrant ladite couche permanente de résine (103),
ii) formation d'au moins une ouverture de l'aire de contact (105) qui s'étend à travers la couche temporaire de résine (104) et la couche permanente de résine (103),
iii) mise en contact du substrat entier (102) comprenant la couche permanente de résine (103), la couche temporaire de résine (104) et l'au moins une aire de contact (101) avec une solution appropriée pour obtenir une première couche conductrice d'ensemencement (106) sur la surface du substrat,
iv) placage électrolytique d'une couche de métal ou d'alliage métallique (107) sur la première couche conductrice d'ensemencement (106), le métal ou l'alliage métallique (107) étant choisi dans le groupe constitué par l'étain, le cuivre, les alliages d'étain et les alliages de cuivre,
**caractérisé par** les étapes de :
v) dépôt d'une couche de réserve (114) sur le métal ou sur l'alliage métallique (107) et modeler ladite couche de réserve (114) pour former des ouvertures révélant la couche de métal ou d'alliage métallique (107) plaquée sur l'au moins une ouverture de l'aire de contact (105),
vi) dépôt d'une couche soudable de couverture (113) dans les ouvertures formées par la couche de réserve (114),
vii) enlèvement de la couche de réserve modelée (114) selon des procédés connus dans l'art et
viii) décapage directement après l'étape vii) d'une quantité de la couche de métal ou d'alliage métallique (107) suffisante pour éliminer la couche de métal ou d'alliage métallique (107) de la première couche conductrice d'ensemencement (106), laissant une couche de métal ou d'alliage métallique (107) dans l'au moins une ouverture de l'aire de contact (105).

2. Procédé selon la revendication 1, le métal ou l'alliage métallique (107) étant choisi dans le groupe constitué par le cuivre et les alliages de cuivre.

3. Procédé selon les revendications 1 ou 2, la couche soudable de couverture (113) étant choisie dans le groupe constitué par l'étain et les alliages d'étain.

4. Procédé selon l'une quelconque des revendications précédentes, une première couche barrière étant plaquée sur l'au moins une aire de contact (101) .

5. Procédé selon l'une quelconque des revendications précédentes, la couche barrière étant constituée d'un métal ou d'un alliage choisi dans le groupe constitué par le nickel, l'étain, le chrome, le titane, l'argent, l'or, le palladium, les alliages correspondants et les couches multiples correspondantes.

6. Procédé selon l'une quelconque des revendications précédentes, la couche temporaire de résine (104) comprenant l'un ou plusieurs parmi les acrylates, le copolymère éthylène/acrylate d'éthyle, le copolymère éthylène/méthacrylate, le copolymère éthylène/acide acrylique, le copolymère éthylène/acrylate de butyle, le poly(méthylpentène) et le poly (méthacrylate de méthyle).

7. Procédé selon la revendication 6, la couche temporaire de résine (104) comprenant en outre une charge choisie dans le groupe constitué par le borate d'aluminium, l'oxyde d'aluminium, le trihydroxyde d'aluminium, l'anthracite, l'antimoniate de sodium, le pentoxyde d'antimoine, le trioxyde d'antimoine, l'apatite, l'attapulgite, le métaborate de baryum, le sulfate de baryum, le sulfate de strontium, le titanate de baryum, la bentonite, l'oxyde de béryllium, le nitrure de bore, le carbonate de calcium, l'hydroxyde de calcium, le sulfate de calcium, le noir de carbone, l'argile, la cristobalite, la terre de diatomées, la dolomite, les ferrites, le feldspath, les billes de verre, le graphite, le silicate de calcium hydraté, l'oxyde de fer, le kaolin, le lithopone, l'oxyde de magnésium, le mica, le disulfure de molybdène, la perlite, les charges polymères telles que le PTFE (polytétrafluoroéthylène), le PE (polyéthylène), le polyimide, la pierre ponce, la pyrophillite, les particules de caoutchouc, la silice pyrogénée, la silice fondue, la silice précipitée, la sépiolite, le quartz, le sable, la farine d'ardoise, le talc, le dioxyde de titane, la vermiculite, la farine de bois, la wollastonite, les zéolithes, le borate de zinc, l'oxyde zinc, le stannate de zinc, le sulfure de zinc, les fibres d'aramide, les fibres de carbone, les fibres de cellulose et les fibres de verre et les mélanges correspondants.

8. Procédé selon l'une quelconque des revendications précédentes, l'au moins une aire de contact (101) comprenant un trou d'interconnexion ou une tranchée.

9. Procédé selon l'une quelconque des revendications précédentes, la première couche conductrice d'ensemencement (106) étant formée par le dépôt autocatalytique d'un métal ou d'un alliage métallique choisi dans le groupe constitué par le cuivre, les alliages cuivre-nickel, les alliages cuivre-ruthénium et les alliages cuivre-rhodium.
